(19)

Europäisches
Patentamt
European
Patent Office
Office européen
des brevets

(11) **EP 2 887 540 A1**

(12) **EUROPEAN PATENT APPLICATION**

(43) Date of publication:
**24.06.2015 Bulletin 2015/26**

(21) Application number: **13198177.1**

(22) Date of filing: **18.12.2013**

(51) Int Cl.:
**H03B 27/00** (2006.01)  **H04B 1/00** (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Telefonaktiebolaget L M Ericsson
(publ)
164 83 Stockholm (SE)**

(72) Inventors:
• **Sivonen, Pete
  FI-21200 Raisio (FI)**

• **Jussila, Jarkko
  FI-20300 Turku (FI)**
• **Suhonen, Markus
  21530 Paimio (FI)**

(74) Representative: **Gray, Peter John Bracey et al
Thompson Gray LLP
Central Court
25 Southampton Buildings
London WC2A 1AL (GB)**

(54) **Local oscillator signal generation**

(57)    A local oscillator signal generation circuit (150) for generating quadrature-related local oscillator signals comprises a source signal generator (153) arranged to generate a differential-mode source signal, a buffer stage (158) coupled to an output (156) of the source signal generator (153) and arranged to buffer the differential-mode source signal, and a quadrature generation stage (170) coupled to an output (168) of the buffer stage (158) and arranged to generate an in-phase local oscillator signal and a quadrature local oscillator signal from the buffered differential-mode source signal. The buffer stage (158) comprises a primary differential amplifier (159) having an input (162) coupled to an input (157) of the buffer stage (158), and a secondary differential amplifier (160) having an input (164) coupled to an output (163) of the primary differential amplifier (159) and an output (165) coupled to the output (168) of the buffer stage (158).

FIG. 2

## Description

Field of the Disclosure

The present disclosure relates to local oscillator generation. More specifically, it relates to a local oscillator signal generation circuit, a wireless receiver and wireless transceiver comprising the local oscillator signal generation circuit, an integrated circuit comprising the wireless receiver, an integrated circuit comprising the wireless transceiver, and a method of generating local oscillator signals.

Background to the Disclosure

A radio receiver for a mobile phone may be designed to receive a radio frequency (RF) signal having a single modulated carrier at a single carrier frequency. Such a radio receiver may have a direct-conversion architecture, where a received signal is down-converted to in-phase and quadrature baseband signals, denoted I and Q respectively, using two local oscillator signals. This down-conversion is known as I/Q down-conversion. Both local oscillator signals have the same frequency, which is equal to the carrier frequency of the received wanted signal, but have a 90 degree phase difference. The phase difference prevents loss of received information. After down-conversion in a direct-conversion receiver, the bandwidth of a wanted signal at baseband is reduced to approximately one half of the bandwidth of the corresponding received RF signal.

Typically, a radio receiver having a direct-conversion architecture comprises an RF band-pass filter for coupling to an antenna, a low noise amplifier (LNA), and a receive chain. The receive chain includes a pair of mixers for I/Q down-conversion, analogue baseband low-pass filters for filtering the in-phase and quadrature baseband signals to attenuate unwanted signals prior to analogue-to-digital conversion, to avoid degradation of signal quality by aliasing due to sampling, analogue-to-digital converters (ADCs) for digitising the in-phase and quadrature baseband signals, and a digital processor for processing the digitised signals. Typically, the radio receiver employs a frequency synthesiser to generate a source signal, and a frequency divider to produce the in-phase and quadrature local oscillator signals by dividing the frequency of the source signal.

It is important that the local oscillator signals have a high spectral purity, that is do not contain, at a significant level, spurious signals at frequencies other than the carrier frequency of the received wanted signal. A spurious signal at such a frequency can, in a receiver having a direct-conversion architecture, result in an unwanted or interfering signal at RF, having the same frequency as the spurious signal, being down-converted into the range of frequencies occupied by the down-converted wanted signal, thereby degrading the signal-to-noise ratio of the wanted signal. More generally, an unwanted or interfering signal at RF having a frequency that differs from a frequency of the spurious signal by an amount up to the bandwidth of the wanted signal can be down-converted into the range of frequencies occupied by the down-converted wanted signal. The spectral purity of the local oscillator signals can also be important in receivers employing architectures other than a direct conversion architecture, where unwanted RF signals at other frequencies may potentially be down-converted into the range of frequencies occupied by the down-converted wanted signal.

Such a problem of spectral impurity of the local oscillator signals can be particularly severe in a receiver employed for carrier aggregation. The term carrier aggregation (CA) refers to the reception of several modulated carrier signals simultaneously. CA receivers are used in modern mobile phones and laptops to enhance data speeds. In intra-band CA, all wanted modulated carrier signals, also referred to herein for brevity as wanted channels, are within a single reception frequency band, that is, the pass-band of one RF filter, which may be off-chip where the receiver is implemented at least partially in an integrated circuit. In intra-band CA, a single off-chip RF filter and one LNA may be used since all wanted channels are within the pass-bands of the filter and LNA. In this case, an integrated circuit needs only one RF input for receiving two or more wanted channels.

In contiguous intra-band CA, there are at least two wanted channels and all wanted channels are adjacent, or next to each other, in the frequency domain. In non-contiguous intra-band CA, all wanted channels are not adjacent, such that in the frequency domain there is a space between some of the channels. There can also be blocking signals between wanted channels. The blocking signals may be, for example, channels allocated for other users or other cellular operators.

In general, the single receive chain described above may not be suitable for contiguous or non-contiguous intra-band CA. For example, a single receive chain is not suitable for non-contiguous intra-band CA if a blocking signal is present between the non-contiguous wanted channels and has a power level that cannot be tolerated by the analogue and/or digital signal processing circuits of the receive chain. In such cases, the signal processing must be divided in the frequency domain into two or more parallel receive chains, and each of the receive chains requires a pair of in-phase and quadrature local oscillator signals for down-converting different subsets of the wanted channels, with each pair having a different frequency, although for the digital processing a single digital processor may be shared by the receive chains. The receiver requires as many pairs of in-phase and quadrature local oscillator signals as there are parallel receive chains. In this case, each of the pairs of local oscillator signals is required to have a high spectral purity.

There is a requirement for improved local oscillator signal generation.

Summary of the Preferred Embodiments

According to a first aspect there is provided a local oscillator signal generation circuit comprising:

a source signal generator arranged to generate a differential-mode source signal;
a buffer stage coupled to an output of the source signal generator and arranged to buffer the differential-mode source signal;
a quadrature generation stage coupled to an output of the buffer stage and arranged to generate an in-phase local oscillator signal and a quadrature local oscillator signal from the buffered differential-mode source signal,
wherein the buffer stage comprises:

a primary differential amplifier having an input coupled to an input of the buffer stage, and
a secondary differential amplifier having an input coupled to an output of the primary differential amplifier and an output coupled to the output of the buffer stage.

According to a second aspect there is provided a method comprising:

generating a differential-mode source signal;
buffering the differential-mode source signal in a buffer stage;
employing a quadrature generation stage to generate an in-phase local oscillator signal and a quadrature local oscillator signal from the buffered differential-mode source signal;
wherein the buffering comprises:

in a primary differential amplifier, at least partially rejecting a primary common-mode signal present at the input of the buffer stage, and
in a secondary differential amplifier having an input coupled to an output of the primary differential amplifier and an output coupled to an output of the buffer stage, at least partially rejecting a secondary common-mode signal present at the input of the secondary differential amplifier.

The primary and secondary differential amplifiers may enable the differential-mode source signal to be delivered to the quadrature generation stage at a sufficiently high level to enable reliable and power-efficient operation of the quadrature generation stage using, for example, digital circuitry. The primary differential amplifier may at least partially reject a primary common-mode signal present at the input of the buffer stage, which may enable a common-mode spurious signal to be reduced in level, relative to a level of the differential-mode source signal delivered to the quadrature generation stage. The secondary differential amplifier may at least partially reject a secondary common-mode signal present at the input of the second amplifier, which may enable a third-order intermodulation product generated by the primary differential amplifier to be further reduced in level relative to a level of the differential-mode source signal delivered to the quadrature generation stage. As the common-mode spurious signal may have a reduced level at the input of the secondary differential amplifier, relative to its level at the input of the primary differential amplifier, a third-order intermodulation product generated by the secondary differential amplifier may be reduced in level.
The primary differential amplifier may be arranged to have a common-mode rejection ratio of at least 10dB. The secondary differential amplifier may be arranged to have a common-mode rejection ratio of at least 10dB. These values enable a local oscillator signal to be generated having a high spectral purity.
The output of the secondary differential amplifier may be coupled to the output of the buffer stage via a high pass filter. Likewise, in the method, the buffering may comprise, after at least partially rejecting the primary common-mode signal in the primary differential amplifier and at least partially rejecting the secondary common-mode signal in the secondary differential amplifier, filtering in a high pass filter the source signal present at an output of the secondary differential amplifier. This feature enables low frequency intermodulation products generated due to second-order non-linearity of the primary and/or secondary differential amplifiers to be attenuated.
The quadrature generation stage may comprise a frequency divider. Likewise, in the method, employing the quadrature generation stage to generate the in-phase local oscillator signal and the quadrature local oscillator signal from the buffered differential-mode source signal may comprise dividing the buffered differential-mode source signal in a frequency divider. This feature enables a precise quadrature relationship between the local oscillator signals, with low complexity.
According to a third aspect, there is provided a wireless receiver comprising a local oscillator signal generation circuit according to the first aspect.
According to a fourth aspect there is provided an integrated circuit comprising a wireless receiver according to the third aspect.
According to a fifth aspect, there is provided a wireless transceiver comprising a wireless receiver according to the third aspect and a transmitter.
According to a sixth aspect there is provided an integrated circuit comprising a wireless transceiver according to the fifth aspect.
According to a seventh aspect, there is provided a wireless receiver, comprising a first local oscillator signal generation circuit and a second local oscillator signal generation circuit, wherein at least one of the first and second local oscillator signal generation circuits is in accordance with the first aspect, wherein the first local oscillator signal generation circuit is arranged to generate first quadrature-related local oscillator signals having a first local oscillator frequency, wherein the second local oscillator signal generation circuit is arranged to generate second quadrature-related local oscillator signals having a second local oscillator frequency, and wherein the wireless receiver comprises a first down-conversion stage arranged to mix at least one carrier signal with the first quadrature-related local oscillator signals and a second down-conversion stage arranged to mix another at least one carrier signal with the second quadrature-related local oscillator signals. Such a wireless receiver may operate in a carrier aggregation mode, receiving contiguous or non-contiguous carrier signals.

According to an eighth aspect, there is provided a wireless transceiver comprising a wireless receiver according to the seventh aspect and a transmitter.

In the wireless transceiver according to the eighth aspect, the transmitter may be arranged to transmit at a transmit frequency lower than the first local oscillator frequency, wherein the source signal of the first local oscillator signal generation circuit has a first source frequency and the source signal of the second local oscillator signal generation circuit has a second source frequency, wherein the second source frequency is higher than the first source frequency, and a difference between the transmit frequency and the first local oscillator frequency may be equal to a difference between the first source frequency and the second source frequency. This feature enables flexibility over the choice of carriers that can be selected for carrier aggregation, by avoiding the need to prohibit such a choice of frequencies.

In the wireless transceiver according to the eighth aspect, the transmitter may be arranged to transmit at a transmit frequency higher than the first local oscillator frequency, wherein the source signal of the first local oscillator signal generation circuit has a first source frequency and the source signal of the second local oscillator signal generation circuit has a second source frequency, wherein the second source frequency is lower than the first source frequency, and a difference between the transmit frequency and the first local oscillator frequency may be equal to a difference between the first source frequency and the second source frequency. This feature enables flexibility over the choice of carriers that can be selected for carrier aggregation, by avoiding the need to prohibit such a choice of frequencies.

The wireless transceiver according to the eighth aspect may be arranged for transmitting and receiving simultaneously.

According to a ninth aspect, there is provided an integrated circuit comprising a wireless receiver according to the eighth aspect.

Preferred embodiments are described, by way of example only, with reference to the accompanying drawings.

Brief Description of the Drawings

Figure 1 is a block schematic diagram of a receiver coupled to an antenna.
Figure 2 is a block schematic diagram of a first local oscillator generation circuit.
Figure 3 is a block schematic diagram of a transceiver.
Figure 4 is a block schematic diagram of a receiver.
Figure 5 is a block schematic diagram of a second local oscillator generation circuit.
Figure 6 illustrates spectra of signals in a receiver.
Figure 7 is a circuit diagram of an amplifier providing common-mode rejection.
Figure 8 is a circuit diagram of a high-pass filter.
Figure 9 is a circuit diagram of another high-pass filter.

Detailed Description of Preferred Embodiments

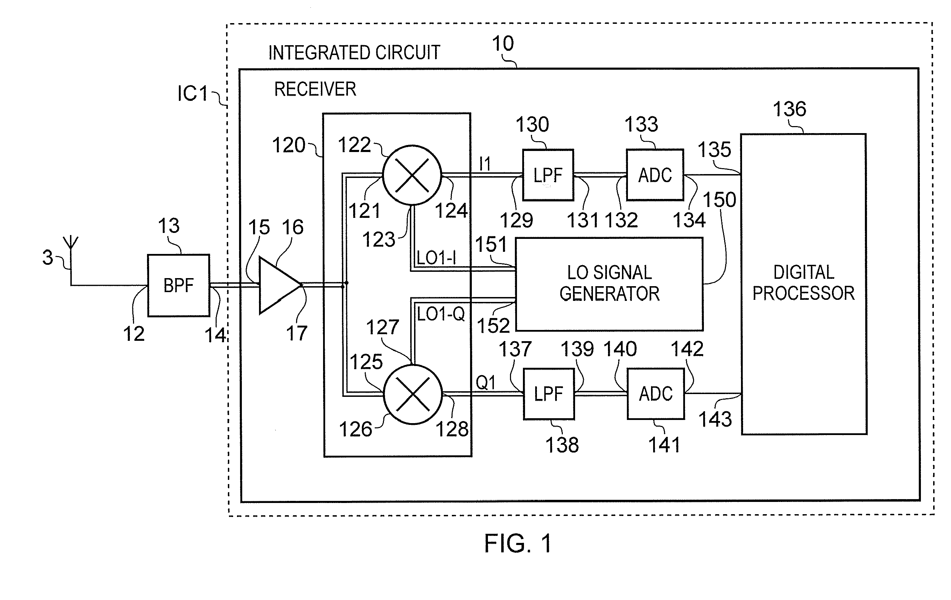

Referring to Figure 1, a receiver 10, having a direct conversion architecture, is coupled to an antenna 3 by means of a band-pass RF filter (BPF) 13. In this embodiment, the receiver 10 is implemented in a first integrated circuit IC1, represented in Figure 1 by a broken line, and in some embodiments the first integrated circuit IC1 also comprises a transmitter. The receiver 10 comprises a low noise amplifier (LNA) 16, and a first receive chain comprising a first down conversion stage 120, a first in-phase low pass filter (LPF) 130, meaning an LPF arranged to filter an in-phase baseband signal I1, a first quadrature LPF 138, meaning an LPF arranged to filter a quadrature baseband signal Q1, a first in-phase analogue-to-digital converter (ADC) 133, meaning an ADC arranged to digitise the low pass filtered first in-phase baseband signal 11, a first quadrature ADC 141, meaning an ADC arranged to digitise the low pass filtered first quadrature baseband signal Q1, and a first digital processor 136. The first down conversion stage 120 comprises a first in-phase down-conversion mixer 122, meaning a mixer arranged to generate the first in-phase baseband signal I1 by down-converting a received RF signal, and a first quadrature down-conversion mixer 126, meaning a mixer arranged to generate the first quadrature baseband signal Q1 by down-converting the received RF signal. The receiver 10 also comprises a first local oscillator (LO) signal generation circuit 150 arranged to generate first in-phase and first quadrature local oscillator signals LO1-I, LO1-Q having the same first LO frequency $F_{LO1}$ and a ninety degree phase difference.

The antenna 3 is coupled to an input 12 of the BPF 13. An output 14 of the BPF 13 is coupled to an input 15 of the LNA 16. An output 17 of the LNA 16 is coupled to a first input 121 of the first in-phase down-conversion mixer 122. A second input 123 of the first in-phase down-conversion mixer 122 is coupled to a first output 151 of the first LO signal generation circuit 150 to receive the first in-phase LO signal LO1-I. An output 124 of the first in-phase down-conversion mixer 122 is coupled to an input 129 of the first in-phase LPF 130. An output 131 of the first in-phase LPF 130 is coupled to an input 132 of the first in-phase ADC 133. An output 134 of the first in-phase ADC 133 is coupled to a first in-phase input 135 of the first digital processor 136.

The output 17 of the LNA 16 is also coupled to a first input 125 of the first quadrature down-conversion mixer 126. A second input 127 of the first quadrature down-conversion mixer 126 is coupled to a second output 152 of the first LO signal generation circuit 150 to receive the first quadrature LO signal LO1-Q. An output 128 of the first quadrature down-conversion mixer 126 is coupled to an input 137 of the first quadrature LPF 138. An output 139 of the first quadrature LPF 138 is coupled to an input 140 of the first quadrature ADC 141. An output 142 of the first quadrature ADC 141 is coupled to a first quadrature input 143 of the first digital processor 136.

The paths of a received RF signal from the output 14 of the BPF 13 to the first inputs 121, 125 of the first in-phase and first quadrature down-conversion mixers 122, 126, including the LNA 16 and the intervening couplings, have a differential format, that is, they are arranged to process and route a differential-mode signal having separate positive and negative signals, where the negative signal is an inversion of the positive signal. Similarly, the paths of the first in-phase and first quadrature LO signals LO1-I, LO1-Q from the first LO signal generation circuit 150 to the respective second inputs 123, 127 of the first in-phase and first quadrature down-conversion mixers 122, 126 are in a differential format. Likewise, the paths of the first in-phase and first quadrature baseband signals I1, Q1 from the respective outputs 124, 128 of the first in-phase and first quadrature down-conversion mixers 122, 126 to the first in-phase and first quadrature ADCs 133, 141, including the first in-phase and first quadrature LPFs 130, 138 and intervening couplings, are also in a differential format. In the drawings, interconnections having a differential format are indicated with a double line. In other embodiments, the path of the received RF signal from the output 14 of the BPF 13 to the input 15 of the LNA 16 may have a single-ended format, with single-ended to differential conversion taking place in the LNA 16.

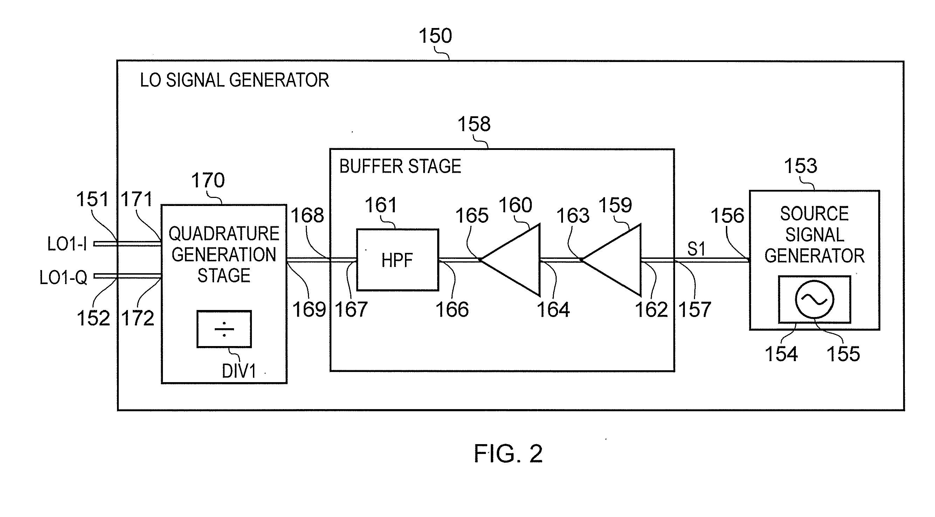

Referring to Figure 2, the first LO signal generation circuit 150 comprises a first source signal generator 153, a buffer stage 158 and a quadrature generation stage 170. The first source signal generator 153 is arranged to generate a first source signal S1 at a first source frequency $F_{S1}$ in a differential format, that is, the first source signal S1 is a differential-mode signal. The first source signal generator 153 comprises a first frequency synthesiser 154 employing a first voltage controlled oscillator (VCO) 155. In one embodiment, the first source frequency $F_{S1}$ is the frequency at which the first VCO 155 oscillates. In other embodiments the first source frequency $F_{S1}$ is obtained from the frequency at which the first VCO 155 oscillates by frequency division in the first frequency synthesiser 154. An output 156 of the first source signal generator 153 is coupled to an input 157 of the first buffer stage 158. The first buffer stage 158 comprises a first primary differential amplifier 159, a first secondary differential amplifier 160, and a first high-pass filter (HPF) 161. The input 157 of the first buffer stage 158 is coupled, in a differential format, to an input 162 of the first primary differential amplifier 159, an output 163 of the first primary differential amplifier 159 is coupled, in a differential format, to an input 164 of the first secondary differential amplifier 160, and an output 165 of the first secondary differential amplifier 160 is coupled, in a differential format, to an input 166 of the first HPF 161. An output 167 of the first HPF 161 is coupled, also in a differential format, to an output 168 of the first buffer stage 158. The first primary differential amplifier 159 is a differential amplifier arranged to at least partially reject any common-mode signal present at its input 162, and therefore present at the input 157 of the first buffer stage 158. Therefore, a signal-to-interference ratio of the differential-mode first source signal S1, where the interference is any common-mode signal, is higher at the output 163 of the first primary differential amplifier 159 than at the input 162 of the first primary differential amplifier 159. In one example, the first primary differential amplifier 159 has a common-mode rejection ratio of at least 10dB. Likewise, the first secondary differential amplifier 160 is a differential amplifier arranged to at least partially reject any common-mode signal present at its input 164. Therefore, a signal-to-interference ratio of the differential-mode first source signal S1, where the interference is any common-mode signal, is higher at the output 165 of the first secondary differential amplifier 160 than at the input 164 of the first secondary differential amplifier 160. In one example, the first secondary differential amplifier 160 has a common-mode rejection ratio of at least 10dB. Indeed, the first primary and first secondary differential amplifiers 159, 160 may be identical. Alternatively, the first secondary differential amplifier 160 may have a lower common-mode rejection ratio than the first primary differential amplifier 159. The first HPF 161 is optional and may be used to attenuate frequencies lower than the first source frequency $F_{S1}$ which may be generated due to non-linearity in the first primary or first secondary differential amplifiers 159, 160. If the first HPF 161 is not present, the output 165 of the first secondary differential amplifier 160 may be coupled directly to the output 168 of the first buffer stage 158.

The output 168 of the first buffer stage 158 is coupled in a differential format to an input 169 of a first quadrature generation stage 170 which generates the first in-phase and first quadrature LO signals LO1-I, LO1-Q. The first quadrature generation stage 170 comprises, in this embodiment, a first frequency divider DIV1 arranged to divide the frequency of the first source signal S1 by two, or another integer, typically a power of two. Indeed, in some embodiments the first quadrature generation stage 170 is the frequency divider DIV1. The first in-phase and first quadrature LO signals LO1-I, LO1-Q have a first LO frequency $F_{LO1}$ equal to a centre frequency, or carrier frequency, of a wanted received RF signal. The first in-phase LO signal LO1-I is delivered, in a differential format, at a first output 171 of the first quadrature generation stage 170 which is coupled to the first output 151 of the first LO signal generation circuit 150, and the first quadrature LO signal LO1-Q is delivered, in a differential format, at a second output 172 of the first quadrature generation stage 170 which is coupled to the second output 152 of the first LO signal generation circuit 150.

Spurious signals present with the first in-phase and first quadrature LO signals LO1-I, LO1-Q, and therefore degrading the spectral purity of these LO signals, can arise in different ways. For example, the first VCO 155 may generate harmonics in addition to its fundamental frequency. If the first VCO 155 is subject to interference, it may also deliver a frequency component at a frequency of the interference, and at harmonics of the frequency of the interference. Furthermore, due to third order non-linearity in the first VCO 155, frequency components may also be generated at frequencies dependent on both the first source frequency $F_{S1}$ and the frequency of the interference. A source of such interference may be another oscillator present in the same device as, and therefore nearby to, the LO generation circuit 150.

Another mechanism by which spurious signals may arise with the first in-phase and first quadrature LO signals LO1-I, LO1-Q is the induction of interference into couplings between elements of the first LO signal generation circuit 150, and in particular into the path of the first source signal S1 between the output 156 of the first source signal generator 153 and the input 157 of the first buffer stage 158, or correspondingly the input 162 of the first primary differential amplifier 159, particularly if this path is relatively long. Third order non-linearity in the first primary or first second amplifiers 159, 160 can result in spurious signals at frequencies dependent on both the first source frequency $F_{S1}$ and the frequency of the induced interference.

One particular source of an unwanted or interfering signal that may be down-converted by a spurious signal present with the first in-phase and first quadrature LO signals LO1-I, LO1-Q into the range of frequencies occupied by the down-converted wanted signal, thereby degrading the signal-to-noise ratio of the wanted signal, is a transmitter implemented in the same device as the receiver 10. Such an unwanted or interfering signal may arise, in particular, due to leakage from the transmitter at a transmission frequency $F_{TX}$.

The problems described above of spurious signals present with the first in-phase and first quadrature LO signals LO1-I, LO1-Q, and interfering signals down-converted by such spurious signals, are of particular concern in a receiver adapted for carrier aggregation, where more than one local oscillator signal may be required, or more especially in a transceiver for carrier aggregation comprising both a transmitter and a receiver, and where the transmitter and receiver are required to operate simultaneously in a Frequency Division Duplex (FDD) mode, particularly where the transmitter and receiver are implemented in a single integrated circuit. Therefore, by way of illustration, the description in the following paragraphs is focussed on such circumstances.

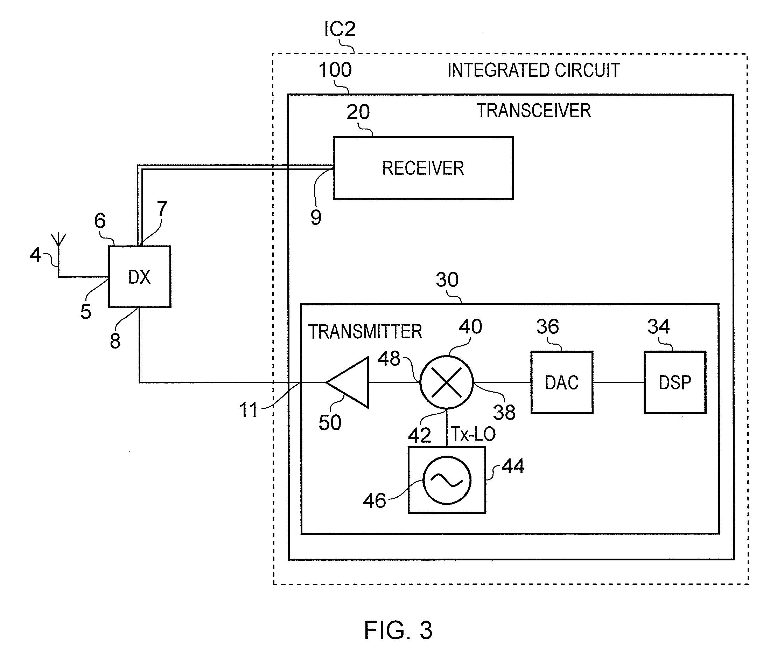

Referring to Figure 3, an antenna 4 is coupled to a first terminal 5 of a duplexer (DX) 6. A transceiver 100 adapted for carrier aggregation, and implemented in a second integrated circuit IC2, comprises a receiver 20 having an input 9 coupled to a second terminal 7 of the duplexer 6, and a transmitter 30 having an output 11 coupled to a third terminal 8 of the duplexer 6.

The transmitter 30 comprises a digital signal processor (DSP) 34 coupled to a digital-to-analogue converter (DAC) 36 arranged to convert a baseband digital signal for transmission generated by the digital signal processor 34 from the digital domain to the analogue domain. The DAC 36 is coupled to a first input 38 of an up-conversion mixer 40 to deliver the baseband analogue signal for transmission to the up-conversion mixer 40. A second input 42 of the up-conversion mixer 40 is coupled to a transmitter frequency synthesiser 44 to receive an up-conversion local oscillator signal TX-LO generated by the transmitter frequency synthesiser 44. The transmitter frequency synthesiser 44 comprises a transmitter VCO 46. The up-conversion local oscillator signal TX-LO has a frequency equal to the transmit frequency $F_{TX}$ of the transmitter 30. By way of example in the following paragraphs, the transmit frequency $F_{TX}$ is considered to be equal to the frequency of the transmitter VCO 46, although this is not essential and instead the transmitter frequency $F_{TX}$ may be obtained from the transmitter VCO 46 by frequency division in the transmitter frequency synthesiser 44. The baseband analogue signal for transmission is up-converted to the transmitter frequency $F_{TX}$ at RF by the up-conversion mixer 40, and an output 48 of the up-conversion mixer 40 is coupled to the output 11 of the transmitter 30 via a power amplifier 50. In other embodiments, the power amplifier 50 may be implemented externally to the second integrated circuit IC2.

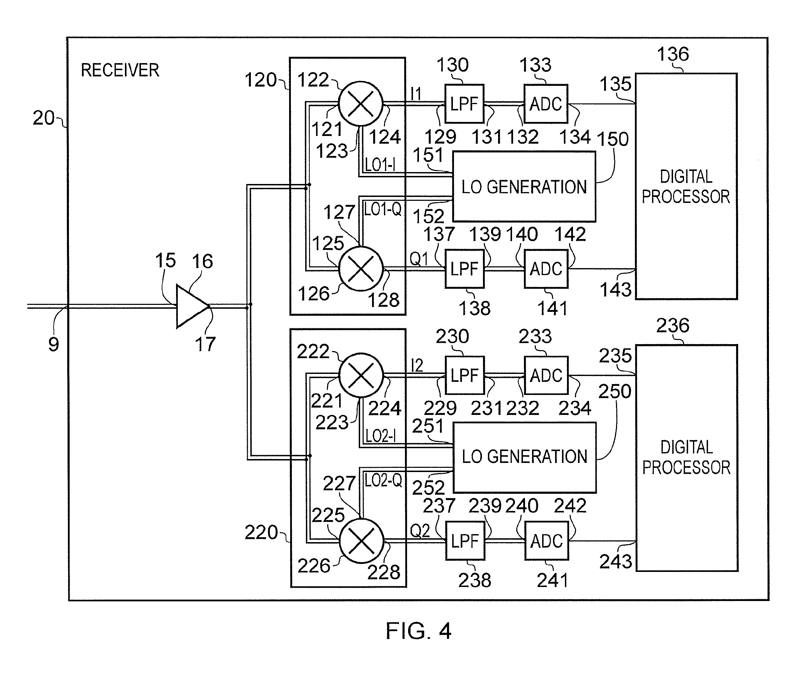

Figure 4 illustrates in more detail the receiver 20 of Figure 3. Referring to Figure 4, the receiver 20 comprises all the elements of the receiver 10 described with reference to Figure 1, coupled together in the same way and operable in the same way, except that, for carrier aggregation, the received signal is a plurality of carrier signals and the elements of the receiver 10 are arranged for receiving a first subset of the plurality of carrier signals, typically on one side of a frequency domain gap in the carrier signals. In addition the receiver 20 of Figure 4 is arranged to receive a second subset of the plurality of carrier signals, typically on the other side of the gap, and comprises a second receive chain comprising a second down conversion stage 220, a second in-phase LPF 230 arranged to filter a second in-phase baseband signal I2, a second quadrature LPF 238 arranged to filter a second quadrature baseband signal Q2, a second in-phase ADC 233 arranged to digitise the low pass filtered second in-phase baseband signal 12, a second quadrature ADC 241 arranged to digitise the low pass filtered second quadrature baseband signal Q2, and a second digital processor 236, although the first and second digital processors 136, 236 may be provided in a common digital processor. The second down conversion stage 220 comprises a second in-phase down-conversion mixer 222 arranged to generate the second in-phase baseband signal 12 by down-converting the second subset of the plurality of carrier signals, and a second quadrature down-conversion mixer 226 arranged to generate the second quadrature baseband signal Q2 by down-converting the second subset of the plurality of carrier signals. The receiver 20 also comprises a second LO signal generation circuit 250 arranged to generate a second in-phase local oscillator signal LO2-I and a second quadrature local oscillator signal LO2-Q both having the same second LO frequency $F_{LO2}$ and a 90 degree phase difference.

The input 15 of the LNA 16 is coupled to the input 9 of the receiver 20. The output 17 of the LNA 16 is, in addition to being coupled to the first input 121 of the first in-phase down-conversion mixer 122 and the first input 125 of the first quadrature down-conversion mixer 126, is coupled to the first input 221 of the second in-phase down-conversion mixer 222. A second input 223 of the second in-phase down-conversion mixer 222 is coupled to a first output 251 of the second LO signal generation circuit 250 to receive the second in-phase LO signal LO2-I. An output 224 of the second in-phase down-conversion mixer 222 is coupled to an input 229 of the second in-phase LPF 230. An output 231 of the second in-phase LPF 230 is coupled to an input 232 of the second in-phase ADC 233. An output 234 of the second in-phase ADC 233 is coupled to a second in-phase input 235 of the second digital processor 236. The output 17 of the LNA 16 is also coupled to a first input 225 of the second quadrature down-conversion mixer 226. A second input 227 of the second quadrature down-conversion mixer 226 is coupled to a second output 252 of the second LO signal generation circuit 250 for receiving the second quadrature LO signal LO2-Q. An output 228 of the second quadrature down-conversion mixer 226 is coupled to an input 237 of the second quadrature LPF 238. An output 239 of the second quadrature LPF 238 is coupled to an input 240 of the second quadrature ADC 241. An output 242 of the second quadrature ADC 241 is coupled to a second quadrature input 243 of the second digital processor 236.

The paths of the received RF signal from the second terminal 7 of the duplexer 6 to the first inputs 221, 225 of the second in-phase and second quadrature down-conversion mixers 222, 226, including the intervening couplings and processing, have a differential format. Similarly, the paths of the second in-phase and second quadrature LO signals LO2-I, LO2-Q from the second LO signal generation circuit 250 to the respective second inputs 223, 227 of the respective second in-phase and quadrature down-conversion mixers 222, 226 are in a differential format. Likewise, the paths of the second in-phase and second quadrature baseband signals I2, 02 from the respective outputs 224, 228 of the second in-phase and second quadrature down-conversion mixers 222, 226 to the first and second in-phase and quadrature ADCs 233, 241, including the second in-phase and second quadrature LPFs 230, and intervening couplings, are also in a differential format.

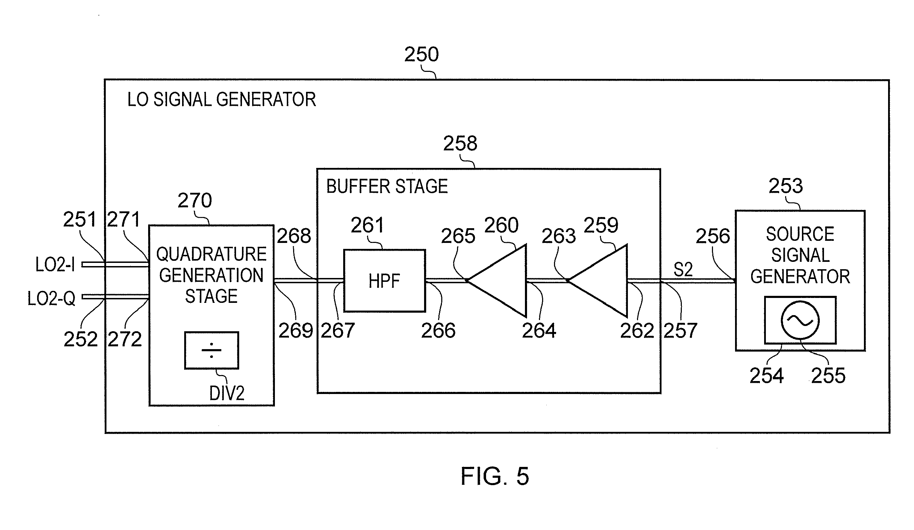

Referring to Figure 5, the second LO signal generation circuit 250 comprises a second source signal generator 253 for generating a second source signal S2 at a second source frequency $F_{S2}$ in a differential format, that is, the second source signal S2 is a differential-mode signal. The second source signal generator 253 comprises a second frequency synthesiser 254 employing a second VCO 255. In one embodiment, the second source frequency $F_{S2}$ is the frequency at which the second VCO 255 oscillates. In other embodiments the second source frequency $F_{S2}$ is obtained from the frequency at which the second VCO 255 oscillates by frequency division in the second frequency synthesiser 254. An output 256 of the second source signal generator 253 is coupled to an input 257 of a second buffer stage 258. The second buffer stage 258 comprises a second primary differential amplifier 259, a second secondary differential amplifier 260, and a second HPF 261. The input 257 of the second buffer stage 258 is coupled, in a differential format, to an input 262 of the second primary differential amplifier 259, an output 263 of the second primary differential amplifier 259 is coupled, in a differential format, to an input 264 of the second secondary differential amplifier 260, and an output 265 of the second secondary differential amplifier 260 is coupled, in a differential format, to an input 266 of the second HPF 261. An output 267 of the second HPF 261 is coupled, also in a differential format, to an output 268 of the second buffer stage 258. The second primary differential amplifier 259 is a differential amplifier arranged to at least partially reject any common-mode signal present at its input 262, and therefore present at the input 257 of the second buffer stage 258. Therefore, a signal-to-interference ratio of the differential-mode second source signal S2, where the interference is any common-mode signal, is higher at the output 263 of the second primary differential amplifier 259 than at the input 262 of the second primary differential amplifier 259. In one embodiment, the second primary differential amplifier 259 has a common-mode rejection ratio of at least 10dB. Likewise, the second secondary differential amplifier 260 is a differential amplifier arranged to at least partially reject any common-mode signal present at its input 264. Therefore, a signal-to-interference ratio of the differential-mode second source signal S2 where the interference is any common-mode signal, is higher at the output 265 of the second secondary differential amplifier 260 than at the input 264 of the second secondary differential amplifier 260. In one example, the second secondary differential amplifier 260 has a common-mode rejection ratio of at least 10dB. Indeed, the second primary and second secondary differential amplifiers 259, 260 may be identical. The second HPF 261 is optional and may be used to attenuate frequencies lower than the second source frequency $F_{S2}$ which may be generated due to non-linearity in the second primary or second secondary differential amplifiers 259, 260. If the second HPF 261 is not present, the output 265 of the second secondary differential amplifier 260 may be coupled directly to the output 268 of the second buffer stage 258.

The output 268 of the second buffer stage 258 is coupled in a differential format to an input 269 of a second quadrature generation stage 270 which generates the second in-phase and second quadrature LO signals LO2-I, LO2-Q. The second quadrature generation stage 270, in this embodiment, comprises a second frequency divider DIV2 arranged to divide the frequency of the second source signal S2 by two, or another integer, typically a power of two. Indeed, in some embodiments the second quadrature generation stage 270 is the frequency divider DIV2. The second in-phase and second quadrature LO signals LO2-I, LO2-Q have a second LO frequency $F_{LO2}$ equal to, in the case of carrier aggregation, a centre frequency of the second subset of the plurality of carriers signals. The second in-phase LO signal LO2-I is delivered, in a differential format, at a first output 271 of the second quadrature generation stage 270 which is coupled to the first output 251 of the second LO signal generation circuit 250, and the second quadrature LO signal LO2-Q is delivered, in a differential format, at a second output 272 of the second quadrature generation stage 270 which is coupled to the second output 252 of the second LO signal generation circuit 250.

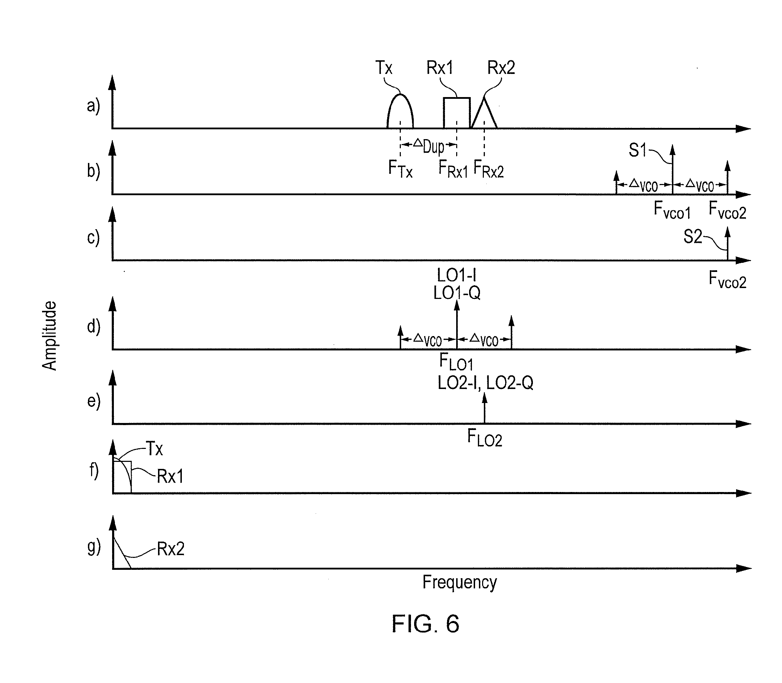

By way of example, in the following paragraphs the first source frequency $F_{S1}$ of the first source signal S1 generated by the first source signal generator 153 is considered to be equal to a first VCO frequency $F_{VCO1}$ at which the first VCO 155 oscillates. Likewise, the second source frequency $F_{S2}$ of the second source signal S2 generated by the second source signal generator 253 is considered to be equal to a second VCO frequency $F_{VCO2}$ at which the second VCO 255 oscillates, and greater than the first source frequency $F_{S1}$. The difference between the second and first VCO frequencies $F_{VCO2}$ and $F_{VCO1}$ is denoted $\Delta_{VCO} = F_{VCO2} - F_{VCO1}$. Figure 6, graph b) illustrates the spectrum of the first VCO 155, having a spectral component at the first VCO frequency $F_{VCO1}$, and Figure 6, graph c) illustrates the spectrum of the second VCO 255, having a spectral component at the second VCO frequency $F_{VCO2}$.

Due to finite isolation between the first and second VCOs 155, 255 in the second integrated circuit IC2, the oscillations couple to each other. For example, considering the first VCO 155 as a victim and the second VCO 255 as an aggressor circuit, the output spectrum of the first VCO 155, and therefore the first source signal S1, consists of a spurious spectral component at frequency $F_{VCO2}$, as illustrated in Figure 6, graph b), in addition to spectral components at the first VCO frequency $F_{VCO1}$

and its harmonics. For clarity, harmonics are not shown in Figure 6. In addition, due to third-order non-linearity of the first VCO 155, a spurious spectral component at a frequency

$$2F_{VCO1} - F_{VCO2} = F_{VCO1} - \Delta_{VCO}$$

is generated by the first VCO 155 with an amplitude proportional to $A_{VCO1}{}^2.A_{VCO2}$, where $A_{VCO1}$ and $A_{VCO2}$ are the voltage amplitudes of spectral components produced by the first VCO 155 at the frequencies $F_{VCO1}$ and $F_{VCO2}$ respectively. It is shown below that the spurious spectral component at the frequency $F_{VCO1} - \Delta_{VCO}$ can be very problematic in an integrated intra-band CA receiver. Therefore, the embodiments aim to minimise generation of a spurious spectral component at this frequency.

Due to third-order non-linearity of the first VCO 155, a spurious spectral component at a frequency

$$2F_{VCO2} - F_{VCO1} = F_{VCO1} + 2\Delta_{VCO}$$

is generated by the first VCO 155, but as its amplitude is proportional to $A_{VCO1}.A_{VCO2}{}^2$, and $A_{VCO2} << A_{VCO1}$, this spurious spectral component is much smaller than the spurious spectral component at frequency $F_{VCO1} - \Delta_{VCO}$. It can therefore be neglected and is not illustrated in Figure 6, graph b).

Figure 6, graph c) illustrates the spectrum of the second VCO 255, having a spectral component at the second VCO frequency $F_{VCO2}$. In addition to the coupling from the second VCO 255 to the first VCO 155 as described above, there can be coupling from the first VCO 155 to the second VCO 255 which results in spurious spectral components in the spectrum of the second VCO 255, but these are not described in detail herein and are not illustrated in Figure 6, graph c).

In the quadrature generation performed by the first quadrature generation stage 170, the spectral components of the first VCO 155 are translated to the first LO frequency $F_{LO1}$ of the first in-phase and first quadrature local oscillator signals LO1-I, LO1-Q. For example, assuming frequency division by two, $F_{LO1} = F_{VCO1}/2$, and the first in-phase and first quadrature local oscillator signals at the first LO frequency $F_{LO1}$ delivered to the first in-phase and first quadrature down-conversion mixers 122, 126 have a spurious spectral component at frequency $F_{LO1} - \Delta_{VCO}$. In addition, the spurious spectral component at the second VCO frequency $F_{VCO2}$ generated by the first VCO 155 is translated to frequency $F_{LO1} + \Delta_{VCO}$ by the frequency division, but as this spurious spectral component is not as harmful as the spurious spectral component at frequency $F_{LO1} - \Delta_{VCO}$, it is not discussed further. Figure 6, graph d) illustrates spectra of the first in-phase and first quadrature local oscillator signals LO1-I, LO1-Q at the first LO frequency $F_{LO1}$, with the spurious spectral components at frequencies $F_{LO1} \pm \Delta_{VCO}$. Figure 6, graph e) illustrates the spectra of the second in-phase and second quadrature local oscillator signals LO2-I, LO2-Q at the second LO frequency $F_{LO2}$. The frequency difference between first and second in-phase local oscillator signals LO1-I, LO2-I, and the frequency difference between first and second quadrature local oscillator signals LO1-Q, LO2-Q is $F_{LO2}$- $F_{LO1} = \Delta_{VCO}/2$, that is, equal to one half of the frequency difference between the first and second VCO frequencies $F_{VCO1}$, $F_{VCO2}$.

The spurious spectral components generated by the first and second VCOs 155, 255 due to direct coupling between the first and second VCOs 155, 255 appear at the outputs 156, 256 of, respectively, the first and second source signal generators 153, 253 as differential-mode signals, and therefore cannot be rejected in the differential-mode circuitry coupled to the outputs 156, 256 of, respectively, the first and second source signal generators 153, 253. However, the isolation between the first and second VCOs 155, 255 operating simultaneously in the second integrated circuit IC2 can be improved by several well-known techniques, such as by employing 8-shaped inductors in the VCO cores, and by increasing the distance between the first and second VCOs 155, 255 in the second integrated circuit IC2. In this way, therefore, the differential-mode signals due to direct coupling between the first and second VCOs 155, 255 can be reduced to a negligible level.

Constraints on integrated circuit layout, including the need to separate the first and second VCOs 155, 255, and the need to locate the first and second quadrature generation stages 170, 270 close to, respectively, the first and second down-conversion stages 120, 220 to minimise signal attenuation can result in a long signal path for the first and second source signals S1, S2 between the outputs 156, 256 of the respective first and second source signal generators 153, 253 and the inputs 169, 269 of the respective first and second quadrature generation stages 170, 270. Typically, the first and second integrated circuits IC1, IC2 are implemented using a sub-micron Complementary Metal Oxide Semiconductor (CMOS) process with, in particular, the first and second quadrature generation stages 170, 270 employing signals having rail-to-rail voltages. However, the first and second source signals S1, S2 may be in the range 1.5GHz to 5GHz and at such frequencies these long signal paths can result in signal attenuation. Therefore, the first and second source signals S1, S2 are amplified or buffered by, respectively, the first and second buffer stages 158, 258, before being delivered to the respective first and second quadrature generation stages 170, 270. The first and second buffer stages 158, 258, which may also be referred to as amplification stages, are located close to the respective first and second quadrature generation stages 170, 270. Consequently, the signal path for the first and second source signals S1, S2 between the outputs 156, 256 of the respective first and second source signal generators 153, 253 and the inputs 157, 257 of the respective first and second buffer stages 158, 258 can be long, for example several millimetres.

Such long signal paths can be a source of interference and also a victim of interference induced by magnetic coupling. For example, interference at the frequency $F_{VCO2}$ can be radiated from the signal path between the output 256 of the second source signal generator 253 and the input 257 of the second buffer stage 258, and this interference can be induced in the signal path between the output 156 of the first source signal generator 153 and the input 157 of the first buffer stage 158 by magnetic coupling. This induced interference is normally in a common-mode, rather than a differential-mode, with signals of the same magnitude and phase, or polarity, being induced in both positive and negative couplings of a differential-mode connection.

As a result, the first source signal S1, which is a differential-mode signal at the frequency $F_{VCO1}$, delivered at the input 157 of the first buffer stage 158 may be accompanied by the differential-mode spurious signals at frequencies $F_{VCO1} \pm \Delta_{VCO}$ due to direct coupling between the first and second VCOs 155, 255, as described above, and also a common-mode spurious signal at $F_{VCO2}$ due to the magnetic coupling as described above. However, as indicated above, techniques such as employing 8-shaped inductors in the VCO cores and increasing the distance between the first and second VCOs 155, 255 can be used to reduce to a negligible level these differential-mode spurious signals.

In the first frequency divider DIV1 of the first quadrature generation stage 170, the common-mode spurious signal at frequency $F_{VCO2}$ together with the desired first source signal S1 at the first source frequency $F_{S1} = F_{VCO1}$ at the input 169 of the first quadrature generation stage 170 can create a differential-mode spurious LO signal at the first in-phase and first quadrature outputs 171, 172 of the first quadrature generation stage 170, at a frequency $F_{LO1} - \Delta_{VCO}$, where $F_{LO1} = F_{VCO1}/2$, assuming division by two in the first frequency divider DIV1, and such a differential-mode spurious LO signal will not be rejected in subsequent circuits that operate in a differential-mode, as differential circuits can reject only common-mode signals.

When the transceiver 100 is employed in an FDD radio system, the transmitter 30 is transmitting in an uplink frequency band, and simultaneously the receiver 20 is receiving in a downlink frequency band. Typically, the uplink frequency band is at a lower frequency than the downlink frequency band, although it may be higher. The frequency separation between the uplink and downlink frequency bands is known as the duplex frequency, and is denoted $\Delta_{DUP}$ herein. During FDD operation, some of the transmitted signal can leak into the receiver 20. Such a transmitter leakage signal can cause desensitisation of the receiver 20. Moreover, when the receiver 20 is used for intra-band carrier aggregation, the spurious LO signal at frequency $F_{VCO1} - \Delta_{VCO}$ can down-convert the transmitter leakage signal to the same frequencies occupied by the desired received signal if the difference between the operating frequencies of the first and second VCOs 155, 255 is equal to the duplex frequency, that is, if

$$\Delta_{DUP} = \Delta_{VCO} = F_{VCO2} - F_{VCO1}$$

because, under these conditions, the frequency of the spurious LO signal is equal to the transmit frequency $F_{TX}$ of the transmitter leakage signal. In practice, because the transmitted signal is, in general, modulated, the transmitter leakage signal will be at least partially down-converted into the frequency range occupied by the wanted RF signal if the frequency separation between the spurious LO signal at frequency $F_{LO1} - \Delta_{VCO}$ and the centre frequency of the transmitter leakage signal is less than the RF bandwidth of the transmitter leakage signal. Here it is assumed that the RF bandwidth of the transmitted signal and the received wanted RF signal are equal. Figure 6, graph a) illustrates spectra of the transmitter leakage signal TX at the transmit frequency $F_{TX}$, the first subset of aggregated carrier signals denoted RX1 at frequency $F_{RX1}$, where $\Delta_{DUP} = F_{RX1} - F_{TX}$ and where $\Delta_{DUP} = \Delta_{VCO}$, and the second subset of aggregated carrier signals denoted RX2 at frequency $F_{RX2}$. Figure 6, graph f) illustrates baseband signals, with the first subset of aggregated carrier signals RX1 down-converted to baseband by the first in-phase and first quadrature local oscillator signals LO1-I, LO1-Q at the first LO frequency $F_{LO1}$, and the transmitter leakage signal TX at the transmit frequency $F_{TX}$ down-converted to baseband by in-phase and quadrature spurious LO signal components at frequency $F_{LO1} - \Delta_{VCO}$, because $F_{TX} = F_{LO1} - \Delta_{VCO}$, hereby degrading the signal-to-noise ratio of the first subset of aggregated carrier signals. Figure 6, graph g) illustrates the second subset of aggregated carrier signals RX2 down-converted to baseband by the second in-phase and second quadrature local oscillator signals LO2-I, LO2-Q at the second LO frequency $F_{LO2}$.

In practice, the power of the wanted received RF signal, comprising the first and second subsets of aggregated carrier signals, can be in the order of -100dBm at the input 15 of the LNA 16, while the transmitter signal leakage power can be about 70dB larger at around -30dBm. Accordingly, assuming that, at the respective inputs 132, 140 of the first in-phase and first quadrature ADCs 133, 141, the down-converted transmitter signal leakage is required to be, for example, at a 10dB lower level than the wanted received signal, so as to limit degradation of the signal-to-noise ratio to a tolerable amount, the level of the spurious LO signal at the frequency $F_{TX}$ of the transmitter leakage signal needs to be at least at 80dB below the level of the first in-phase and first quadrature LO signals LO1-I, LO1-Q at the second inputs 123, 127 of, respectively, the first in-phase and first quadrature up-conversion mixers 122, 126.

The first buffer stage 158 operates, as described below, to reduce the degradation of the signal-to-noise ratio of the down-converted first subset of aggregated carrier signals RX1 due to the down-conversion of transmitter leakage by a spurious LO signal at frequency $F_{LO1} - \Delta_{VCO}$. The first buffer stage 158 is arranged to do this by rejecting, the common-mode spurious signal at frequency $F_{VCO2}$ that is induced in the connection between the output 156 of the first source signal generator 153 and the input 157 of the first buffer stage 158 reducing the level of the spurious LO signal, relative to the level of the first source signal S1, before it reaches the first quadrature generation stage 170. Without the first buffer stage 158 operating as described below, the level of the common-mode spurious signal at frequency $F_{VCO2}$ may be in the order of 1 mV, while the differential-mode first source signal S1 at frequency $F_{VCO1}$ may be in the order of 400mV at the input 169 of the first quadrature generation stage 170. Correspondingly, the second buffer stage 258 can reduce the degradation of the signal-to-noise ratio of the down-converted second subset of aggregated carrier signals RX2 due to an interfering signal.

Referring to Figure 2, the first primary and first secondary differential amplifiers 159, 160, in addition to amplifying the differential-mode first source signal S1 to a suitable level for driving the first quadrature generation stage 170, are both arranged to provide attenuation, relative to the level of the first source signal S1, of common-mode signals in order to attenuate, in particular, the spurious signal at frequency $F_{VCO2}$ induced by, for example, magnetic coupling.

Due to third-order non-linearity of the first primary differential amplifier 159, a third-order intermodulation product at frequency $F_{VCO1} - \Delta_{VCO}$ is generated and is present at the output 163 of the first primary differential amplifier 159. As the induced spurious signal at frequency $F_{VCO2}$ is a common-mode signal, this intermodulation product is also a common-mode signal, and is therefore at least partially rejected, or attenuated, in the first secondary differential amplifier 160. Generation of a third-order intermodulation product at frequency $F_{VCO1} - \Delta_{VCO}$ by the first secondary differential amplifier 160 is reduced, relative to that generated by the first primary differential amplifier 159, because the spurious signal at frequency $F_{VCO2}$ is attenuated in the first primary differential amplifier 159. In this way, the combination of the first primary and first secondary differential amplifiers 159, 160 in cascade reduces the level of spurious signal at frequency $F_{VCO1} - \Delta_{VCO}$ accompanying the first source signal S1 delivered at the input 169 of the first quadrature generation stage 170, and consequently reduces the level of spurious signal at frequency $F_{LO1} - \Delta_{VCO}$ accompanying the first in-phase and first quadrature LO signals LO1-I, LO1-Q delivered by the first quadrature generation stage 170 to the second inputs 123, 127 of the first in-phase and first quadrature mixers 122, 126, hereby reducing the amount of unwanted signal at frequency $F_{LO1} - \Delta_{VCO}$ that is down-converted into the bandwidth of the received wanted signal, that is, the first subset of the carriers RX1. In particular, in a transceiver where $\Delta_{VCO} = \Delta_{DUP}$, the impact of transmitter leakage is reduced.

Second order non-linearity in the first primary and first secondary differential amplifiers 159, 160 can result in a differential-mode further spurious signal at a relatively low frequency $F_{VCO2} - F_{VCO1} = \Delta_{VCO}$ being generated from the first source signal S1 at frequency $F_{VCO1}$ and the induced spurious signal at frequency $F_{VCO2}$. This further spurious signal is up-converted by frequency division in the first quadrature generation stage 170 to the frequency $F_{LO1} - \Delta_{VCO}$, where it can result in down-conversion of the transmitter leakage, degrading the signal-to-noise ratio of the down-converted wanted signal. Therefore, the first high-pass filter 159 is arranged attenuate this further spurious signal at low frequency, prior to the division in the first quadrature generation stage 170, in order to reduce such degradation.

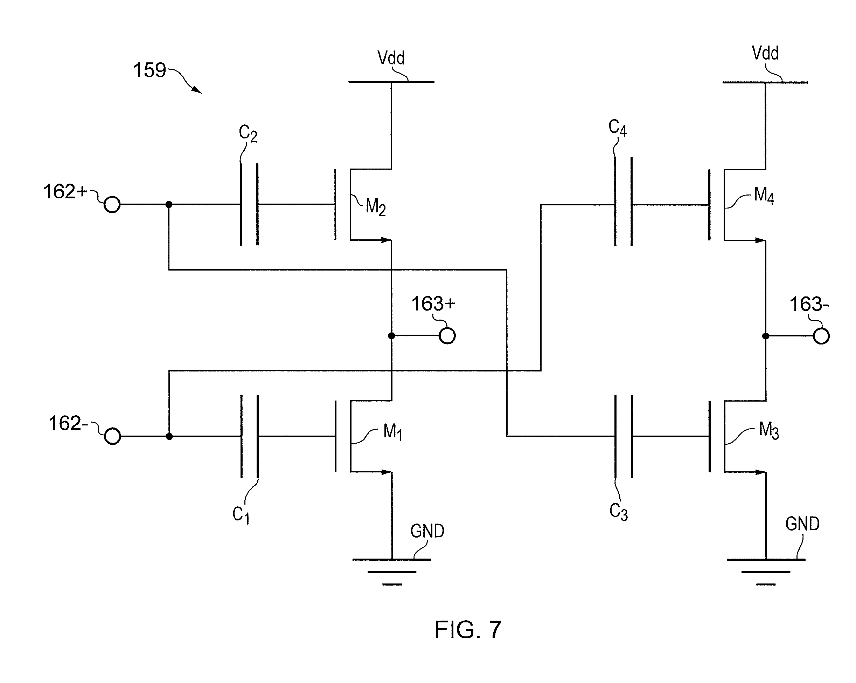

Referring to Figure 7, an embodiment of the first primary differential amplifier 159, which may also be used for the first secondary differential amplifier 160 and the second primary and second secondary differential amplifiers 259, 260, comprises a first n-channel metal oxide semiconductor (NMOS) transistor M1 having a source coupled to ground GND, a drain coupled to a positive output terminal 163+ of the output 163, the latter having a differential format, of the first primary differential amplifier 159, and a gate coupled to a negative input terminal 162- of the input 162, which also has a differential format, of the first primary differential amplifier 159 by means of a first direct current (DC) blocking capacitor $C_1$. A second NMOS transistor M2 has a source coupled to the positive output terminal 163+, a drain coupled to a positive voltage rail Vdd, and a gate coupled to a positive input terminal 162+ of the input 162 of the first primary differential amplifier 159 by means of a second DC blocking capacitor $C_2$. The first and second DC blocking capacitors $C_1$, $C_2$ are arranged to act as short circuits to the first source signal S1 at the first source frequency $F_{S1}$. A third NMOS transistor M3 has a source coupled to ground GND, a drain coupled to a negative output terminal 163- of the output 163 of the first primary differential amplifier 159, and a gate coupled to the positive input terminal 162+ by means of a third DC blocking capacitor $C_3$. A fourth NMOS transistor M4 has a source coupled to the negative output terminal 163-, a drain coupled to the positive voltage rail Vdd, and a gate coupled to the negative input terminal 162- by means of a fourth DC blocking capacitor $C_4$. For clarity, biasing details are omitted from Figure 7. If the first to fourth NMOS transistors M1...M4 are biased at equal current levels and their aspect ratios, or dimensions, are equal, the circuit described with reference to Figure 7 provides attenuation, or at least partial rejection, of common-mode signals.

The use of one or more CMOS inverters in cascade, in place of the first and second primary and secondary differential amplifiers 159, 160, 259, 260, although delivering rail-to-rail signal voltages to the input 169 of the first quadrature generation stage 170 and to the input 269 of the second quadrature generation stage 270, do not provide common-mode attenuation, and therefore cannot provide the benefits disclosed herein provided by the first and second primary and secondary differential amplifiers 159, 160, 259, 260. Moreover, such inverters can increase the level of spurious local oscillator signals because third order intermodulation products generated by one CMOS inverter would be amplified by a second, subsequent CMOS inverter, and the second CMOS inverter would itself generate additional third order intermodulation distortion.

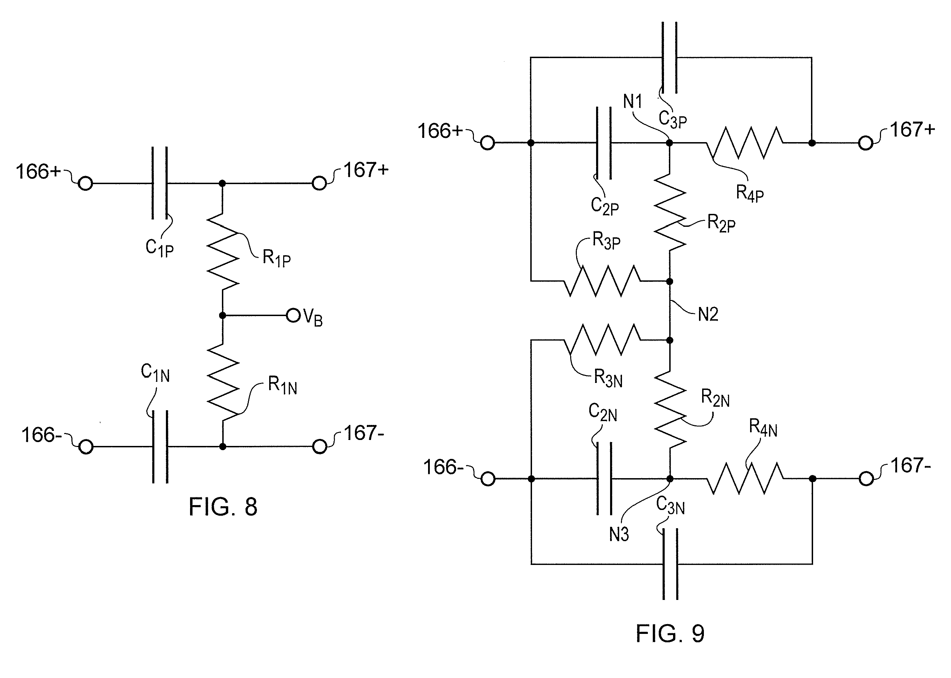

Referring to Figure 8, a first embodiment of the first HPF 161, which may also be used for the second HPF 261, comprises a first filter capacitor $C_{1P}$ coupled between a positive input terminal 166+ of the input 166 of the first HPF 161 and a positive output terminal 167+ of the output 167 of the first HPF 161. A second filter capacitor $C_{1N}$ is coupled between a negative input terminal 166- of the input 166 of the first HPF 161 and a negative output terminal 167- of the output 167 of the first HPF 161. A first filter resistor $R_{1P}$ is coupled between the positive output terminal 167+ and a bias voltage $V_B$, and a second filter resistor $R_{1N}$ is coupled between the negative output terminal 167- and the bias voltage $V_B$. This first embodiment of the first HPF 161 biases the input 169 of the quadrature generation stage 170 to the bias voltage $V_B$.

Referring to Figure 9, a second, alternative embodiment of the first HPF 161, which may also be used for the second HPF 261, comprises a third filter capacitor $C_{2P}$ coupled between the positive input terminal 166+ of the input 166 of the first HPF 161 and a first node N1, a fourth filter capacitor $C_{3P}$ coupled between the positive input terminal 166+ and the positive output terminal 167+ of the output 167 of the first HPF 161, a third filter resistor $R_{2P}$ coupled between the first node N1 and a second node N2, a fourth filter resistor $R_{3P}$ coupled between the positive input terminal 166+ and the second node N2, and a fifth filter resistor $R_{4P}$ coupled between the first node N1 and the positive output terminal 167+. There is also a fifth filter capacitor $C_{2N}$ coupled between the negative input terminal 166- of the input 166 of the first HPF 161 and a third node N3, a sixth filter capacitor $C_{3N}$ coupled between the negative input terminal 166- and the negative output terminal 167- of the output 167 of the first HPF 161, a sixth filter resistor $R_{2N}$ coupled between the third node N3 and the second node N2, a seventh filter resistor $R_{3N}$ coupled between the negative input terminal 166- and the second node N2, and an eighth filter resistor $R_{4N}$ coupled between the third node N3 and the negative output terminal 167-. This second embodiment of the first HPF 161 couples a common-mode DC voltage level from its input 166 to its output 167, thereby enabling this common-mode DC voltage to be utilised in biasing the quadrature generation stage 170.

Although embodiments have been described in which the first source frequency $F_{S1}$ is equal to the first VCO frequency $F_{VCO1}$, and the second source frequency

$F_{S2}$ is equal to the second VCO frequency $F_{VCO2}$, in other embodiments the first source frequency $F_{S1}$ may be obtained from the first VCO frequency $F_{VCO1}$ at which the first VCO 155 oscillates by frequency division in the first frequency synthesiser 154, and/or the second source frequency $F_{S2}$ may be obtained from the second VCO frequency $F_{VCO2}$ at which the second VCO 255 oscillates by frequency division in the second frequency synthesiser 254. For such embodiments, due to finite isolation between the first and second local oscillator generation circuits 150, 250, the spurious spectral components may be generated at a frequency spacing of $\Delta_S = |F_{S1} - F_{S2}|$ either side of the first and second source signals S1, S2. The scenario illustrated in, and described with reference to, Figure 6 may be adapted to such embodiments by, in Figure 6, replacing the first and second VCO frequencies $F_{VCO1}$, $F_{VCO2}$ by the first and second source frequencies $F_{S1}$, $F_{S2}$ and by replacing $\Delta_{VCO}$ by $\Delta_S$.

Although embodiments have been described in which the second VCO frequency $F_{VCO2}$ is higher than the first VCO frequency $F_{VCO1}$, the second LO frequency $F_{LO2}$ is higher than the first LO frequency $F_{LO1}$, and the second source frequency $F_{S2}$ is higher than the first source frequency $F_{S1}$, the reverse relationship between the various first and second frequencies may alternatively apply, with, for example, the second VCO frequency $F_{VCO2}$ being lower than the first VCO frequency $F_{VCO1}$. In the description and claims, references to a difference between two frequencies are intended to refer to the magnitude of such a difference, and are not intended to imply that one particular frequency is higher than another frequency. Therefore, the difference between the second and first VCO frequencies $F_{VCO2}$ and $F_{VCO1}$, denoted $\Delta_{VCO}$, may be more generally denoted as the modulus of $F_{VCO2} - F_{VCO1}$, that is, $|F_{VC2} - F_{VCO1}|$ or the modulus of $F_{VCO1} - F_{VCO2}$, that is, $|F_{VCO1} - F_{VCO2}|$. Likewise, the duplex frequency $\Delta_{DUP}$ always has a positive value.

Furthermore, although embodiments of a wireless transceiver have been described in which the transmit frequency $F_{TX}$ is lower than the frequencies $F_{RX1}$ and $F_{RX2}$ at which it receives, in other embodiments the transmit frequency $F_{TX}$ may be higher than the frequencies $F_{RX1}$ and $F_{RX2}$ at which the transceiver receives. In some embodiments of a wireless transceiver 100, the transmit frequency $F_{TX}$ of the transmitter 30 is lower than the first LO frequency $F_{LO1}$ of the first in-phase and quadrature LO signals LO1-I, LO1-Q, the source signal S1 of the first local oscillator signal generation circuit 150 has the first source frequency $F_{S1}$ and the source signal S2 of the second local oscillator signal generation circuit 250 has the second source frequency $F_{S2}$, where the second source frequency $F_{S2}$ is higher than the first source frequency $F_{S1}$, and the difference between the transmit frequency $F_{TX}$ and the first LO frequency $F_{LO1}$ is equal to the difference $\Delta_S$ between the first source frequency $F_{S1}$ and the second source frequency $F_{S2}$. In other embodiments of a wireless transceiver 100, the transmit frequency $F_{TX}$ the transmitter 30 is higher than the first LO frequency $F_{LO1}$ of the first in-phase and quadrature LO signals LO1-I, LO1-Q, the second source frequency $F_{S2}$ is lower than the first source frequency $F_{S1}$, and the difference between the transmit frequency $F_{TX}$ and the first LO frequency $F_{LO1}$ is equal to the difference $\Delta_S$ between the first source frequency $F_{S1}$ and the second source frequency $F_{S2}$.

Although embodiments have been described employing a direct-conversion receiver architecture, this is not essential and the disclosed local oscillator signal generation circuit may be used with other receiver architectures, such as a low intermediate (IF) architecture, or an architecture employing more than one stage of frequency down-conversion.

Although embodiments have been described employing a transmitter having a direct conversion architecture, this is not essential and other transmitter architectures employing more than one stage of frequency up-conversion may be employed.

The disclosed local oscillator signal generation circuit is particularly advantageous for multi-mode and multi-band wireless receivers and transceivers, for example that can have as many as 10 to 20 receiver inputs, as in this case the synthesiser output signals may have to be routed to several receivers, thereby increasing the opportunity of radiation and induction of spurious signals.

Although the disclosed local oscillator signal generation circuit has been described in particular in relation to a receiver and transceiver adapted for carrier aggregation, its application is not limited to such a receiver or transceiver, and it may be used advantageously in other types of receiver or transceiver, for example for receiving a single carrier.

Although the receiver 20 illustrated in Figure 4 has been described with reference to non-contiguous carrier aggregation, the receiver 20 may also be used for contiguous carrier aggregation, where there is no gap between the first and second subsets of the plurality of carrier signals.

Although embodiments of a transceiver have been described in which a transmitter is arranged to transmit at a transmit frequency lower than the frequencies at which the transceiver receives, in other embodiments the transmit frequency may be higher than the receive frequencies. In particular, in a transceiver in which a receiver is arranged to generate first quadrature-related local oscillator signals having a first frequency and second quadrature-related local oscillator signals having a second frequency, the transmit frequency may be different to the first and second frequencies, and a difference between the transmit frequency and the first frequency may be equal to a difference between the first frequency and the second frequency. Therefore, the transmit frequency may be higher than both the first and second frequencies, or lower than both the first and second frequencies.

Although the disclosed local oscillator signal generation circuit has been described in particular in relation to a receiver and transceiver for a mobile phone, its application is not limited to such a receiver or transceiver.

Although embodiments have been described employing FDD, and having a duplex frequency equal to a frequency difference between the first and second source signals, and more particularly equal to a frequency difference between the first and second VCOs 155, 255, the disclosed local oscillator signal generation circuit may be employed advantageously in applications where these limitations are not present.

Although embodiments have been described in which a receiver or transceiver is implemented in an integrated circuit, this is not an essential feature.

Other variations and modifications will be apparent to the skilled person. Such variations and modifications may involve equivalent and other features which are already known and which may be used instead of, or in addition to, features described herein. Features that are described in the context of separate embodiments may be provided in combination in a single embodiment. Conversely, features which are described in the context of a single embodiment may also be provided separately or in any suitable subcombination.

It should be noted that the term "comprising" does not exclude other elements or steps, the term "a" or "an" does not exclude a plurality, a single feature may fulfil the functions of several features recited in the claims and reference signs in the claims shall not be construed as limiting the scope of the claims. It should also be noted that where a component is described as being "arranged to" or "adopted to" perform a particular function, it may be appropriate to consider the component as merely suitable "for" performing the function, depending on the context in which the component is being considered. Throughout the text, these terms are generally considered as interchangeable, unless the particular context dictates otherwise. It should also be noted that the Figures are not necessarily to scale; emphasis instead generally being placed upon illustrating the principles of the present invention.

**Claims**

1.  A local oscillator signal generation circuit (150) comprising:

    a source signal generator (153) arranged to generate a differential-mode source signal;
    a buffer stage (158) coupled to an output (156) of the source signal generator (153) and arranged to buffer the differential-mode source signal;
    a quadrature generation stage (170) coupled to an output (168) of the buffer stage (158) and arranged to generate an in-phase local oscillator signal and a quadrature local oscillator signal from the buffered differential-mode source signal,
    wherein the buffer stage (158) comprises:

    a primary differential amplifier (159) having an input (162) coupled to an input (157) of the buffer stage (158), and
    a secondary differential amplifier (160) having an input (164) coupled to an output (163) of the primary differential amplifier (159) and an output (165) coupled to the output (168) of the buffer stage (158).

2.  A local oscillator signal generation circuit (150) as claimed in claim 1, wherein the output (165) of the secondary differential amplifier (160) is coupled to the output (168) of the buffer stage (158) via a high pass filter (161).

3.  A local oscillator signal generation circuit (150) as claimed in any preceding claim, wherein the quadrature generation stage (170) comprises a frequency divider (DIV1).

4.  A wireless receiver (10) comprising a local oscillator signal generation circuit (150) as claimed in any preceding claim.

5.  An integrated circuit (IC1) comprising a wireless receiver (10) as claimed in claim 4.

6.  A wireless transceiver (100) comprising a wireless receiver (10) as claimed in claim 4 and a transmitter (30).

7.  A wireless receiver (20), comprising a first local oscillator signal generation circuit (150) and a second local oscillator signal generation circuit (250), wherein at least one of the first and second local oscillator signal generation circuits (150, 250) is as claimed in any one of claims 1 to 3, wherein the first local oscillator signal generation circuit (150) is arranged to generate first quadrature-related local oscillator signals having a first local oscillator frequency, and wherein the second local oscillator signal generation circuit (250) is arranged to generate second quadrature-related local oscillator signals having a second local oscillator frequency, and wherein the wireless receiver (20) comprises a first down-conversion stage (120) arranged to mix at least one carrier signal with the first quadrature-related local oscillator signals and a second down-conversion stage (220) arranged to mix another at least one carrier signal with the second quadrature-related local oscillator signals.

8.  An integrated circuit (IC2) comprising a wireless receiver (20) as claimed in claim 7.

**9.** A wireless transceiver (100) comprising a wireless receiver (20) as claimed in claim 7 and a transmitter (30).

**10.** A wireless transceiver (100) as claimed in claim 9, wherein the transmitter (30) is arranged to transmit at a transmit frequency lower than the first local oscillator frequency, wherein the source signal of the first local oscillator signal generation circuit (150) has a first source frequency and the source signal of the second local oscillator signal generation circuit (250) has a second source frequency, wherein the second source frequency is higher than the first source frequency, and wherein a difference between the transmit frequency and the first local oscillator frequency is equal to a difference between the first source frequency and the second source frequency.

**11.** A wireless transceiver (100) as claimed in claim 9, wherein the transmitter (30) is arranged to transmit at a transmit frequency higher than the first local oscillator frequency, wherein the source signal of the first local oscillator signal generation circuit (150) has a first source frequency and the source signal of the second local oscillator signal generation circuit (250) has a second source frequency, wherein the second source frequency is lower than the first source frequency, and wherein a difference between the transmit frequency and the first local oscillator frequency is equal to a difference between the first source frequency and the second source frequency.

**12.** A wireless transceiver (100) as claimed in claim 10 or claim 11, arranged to transmit and receive simultaneously.

**13.** An integrated circuit (IC2) comprising a wireless transceiver (100) as claimed in any one of claims 9 to 12.

**14.** A method comprising:

generating a differential-mode source signal;
buffering the differential-mode source signal in a buffer stage (158);
employing a quadrature generation stage to generate an in-phase local oscillator signal and a quadrature local oscillator signal from the buffered differential-mode source signal,
wherein the buffering comprises:

in a primary differential amplifier (159), at least partially rejecting a primary common-mode signal present at an input (157) of the buffer stage (158), and
in a secondary differential amplifier (160) having an input (164) coupled to an output (163) of the primary differential amplifier (159) and an output (165) coupled to an output (168) of the buffer stage (158), at least partially rejecting a secondary common-mode signal present at the input (164) of the secondary differential amplifier (160).

**15.** A method as claimed in claim 13, wherein the buffering comprises, after at least partially rejecting the primary common-mode signal in the primary differential amplifier and at least partially rejecting the secondary common-mode signal in the secondary differential amplifier, filtering in a high pass filter the source signal present at an output of the secondary differential amplifier.

FIG. 1

EP 2 887 540 A1

FIG. 2

EP 2 887 540 A1

FIG. 3

FIG. 4

FIG. 5

FIG. 6

FIG. 7

FIG. 8

FIG. 9

Europäisches
Patentamt

European
Patent Office

Office européen
des brevets

## EUROPEAN SEARCH REPORT

Application Number

EP 13 19 8177

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 377 315 B1 (CARR FRANK [US] ET AL) 23 April 2002 (2002-04-23) | 1,3-14 | INV. H03B27/00 H04B1/00 |
| Y | * figures 12-15, 51,52 * * column 1, lines 26-29 * * column 4, line 32 * * column 59, line 46 - line 48 * | 2,15 | |
| Y | WO 2005/107059 A1 (KONINKL PHILIPS ELECTRONICS NV [NL]; PHILIPS CORP [US]; FRAMBACH JOHAN) 10 November 2005 (2005-11-10) * figure 3 * | 2,15 | |
| A | US 2012/120992 A1 (SOLTANIAN BABAK [US] ET AL SAVOJ JAFAR [US] ET AL) 17 May 2012 (2012-05-17) * figure 1 * | 1-15 | |
| A | US 2009/174486 A1 (HARALABIDIS NIKOLAOS C [GR] ET AL) 9 July 2009 (2009-07-09) * figure 3 * | 1-15 | TECHNICAL FIELDS SEARCHED (IPC) |
| A | US 2012/049920 A1 (KURACHI SATOSHI [JP]) 1 March 2012 (2012-03-01) * figure 5 * | 1-15 | H03B H04B |

The present search report has been drawn up for all claims

| Place of search | Date of completion of the search | Examiner |
|---|---|---|
| Munich | 12 May 2014 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 13 19 8177

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2014

| Patent document cited in search report | | Publication date | Patent family member(s) | | | Publication date |
|---|---|---|---|---|---|---|
| US 6377315 | B1 | 23-04-2002 | AT | 276605 | T | 15-10-2004 |
| | | | AU | 2147900 | A | 29-05-2000 |
| | | | DE | 69920273 | D1 | 21-10-2004 |
| | | | DE | 69920273 | T2 | 22-09-2005 |
| | | | EP | 1145430 | A2 | 17-10-2001 |
| | | | US | 6285865 | B1 | 04-09-2001 |
| | | | US | 6377315 | B1 | 23-04-2002 |
| | | | US | 6504420 | B1 | 07-01-2003 |
| | | | US | 6591091 | B1 | 08-07-2003 |
| | | | US | 2001007151 | A1 | 05-07-2001 |
| | | | US | 2001008430 | A1 | 19-07-2001 |
| | | | US | 2001011013 | A1 | 02-08-2001 |
| | | | US | 2002140869 | A1 | 03-10-2002 |
| | | | US | 2003022646 | A1 | 30-01-2003 |
| | | | US | 2003107427 | A1 | 12-06-2003 |
| | | | US | 2003162521 | A1 | 28-08-2003 |
| | | | US | 2003194978 | A1 | 16-10-2003 |
| | | | US | 2005107055 | A1 | 19-05-2005 |
| | | | US | 2005153677 | A1 | 14-07-2005 |
| | | | US | 2007013433 | A1 | 18-01-2007 |
| | | | US | 2007077908 | A1 | 05-04-2007 |
| | | | US | 2007120605 | A1 | 31-05-2007 |
| | | | US | 2008284919 | A1 | 20-11-2008 |
| | | | US | 2010237884 | A1 | 23-09-2010 |
| | | | US | 2011067083 | A1 | 17-03-2011 |
| | | | WO | 0028664 | A2 | 18-05-2000 |
| WO 2005107059 | A1 | 10-11-2005 | CN | 1985436 | A | 20-06-2007 |
| | | | EP | 1745544 | A1 | 24-01-2007 |
| | | | JP | 2007535855 | A | 06-12-2007 |
| | | | KR | 20070004890 | A | 09-01-2007 |
| | | | WO | 2005107059 | A1 | 10-11-2005 |
| US 2012120992 | A1 | 17-05-2012 | CN | 103329441 | A | 25-09-2013 |
| | | | EP | 2641332 | A1 | 25-09-2013 |
| | | | JP | 2014502464 | A | 30-01-2014 |
| | | | KR | 20130110199 | A | 08-10-2013 |
| | | | US | 2012120992 | A1 | 17-05-2012 |
| | | | US | 2014029653 | A1 | 30-01-2014 |
| | | | WO | 2012068326 | A1 | 24-05-2012 |
| US 2009174486 | A1 | 09-07-2009 | NONE | | | |
| US 2012049920 | A1 | 01-03-2012 | JP | 2012049882 | A | 08-03-2012 |
| | | | US | 2012049920 | A1 | 01-03-2012 |

EPO FORM P0459

For more details about this annex : see Official Journal of the European Patent Office, No. 12/82